# EUROPEAN PATENT APPLICATION

(11) **EP 2 589 973 A1**
(43) Date of publication of application: **08.05.2013**
(21) Application number: 11187665.2
(22) Date of filing: 03.11.2011
(51) Int. Cl.: G01R 31/02, G01R 31/28, H02H 3/16, D06F 39/00

(54) **Ground power leakage detection for peripheral printed circuit boards**

(71) Applicant: Electrolux Home Products Corporation N.V., 1130 Brussel (BE)
(72) Inventor: Cecco, Alessandro, 33080 Porcia (PN) (IT); Driussi, Paolo, 33080 Porcia (PN) (IT); Lorenzi, Marco, 33080 Porcia (PN) (IT); Dorigo, Hubert, 33080 Porcia (PN) (IT)
(74) Representative: Maccalli, Marco

(57) **Abstract**

The present invention relates to an electric appliance **(100)** comprising an electric load **(225),** and a printed circuit board assembly **(115)** for electronically managing the electric appliance **(100);** the printed circuit board assembly comprises a slave printed circuit board **(220s)** operatively associated with the electric load **(225)** for driving it, and a master printed circuit board **(220m)** operatively associated with the slave printed circuit board **(220s)** and arranged for receiving an electric power supply **(L,N)** of the electric appliance and for selectively providing/stopping the provision of an operative electric power to the slave printed circuit board **(220s)** for energization/de-energization thereof. The master printed circuit board **(220m)** comprises a detection device **(R_{SENSE},T_{1SENSE},T_{2SENSE})** for detecting a dispersion of electric power towards ground of the electric load **(225)** and/or of the slave printed circuit board **(220s)** when the operative electric power is not provided to said slave printed circuit board **(220s),** and for providing, in response to the detecting, a control parameter indicative of the dispersion of electric power towards ground. The master printed circuit board **(220m)** further comprises a control unit **(250)** configured for receiving the control parameter, comparing the control parameter to a preset threshold value or range of values, and enabling provision of the operative electric power to the slave printed circuit board **(220s)** according to a result of such comparison.

## Description

### Field of the invention

The present invention generally relates to electric appliances, such as washing machines, washers/dryers, dryers, dishwashers, refrigerators, ovens, both for domestic and professional use. More particularly, the present invention relates to detection of electrical faults, such as power dispersion towards earth or ground, in such electric appliances.

### Background of the invention

Each electric household and professional appliance (hereinafter, appliance, for the sake of conciseness) comprises various electric, electro-mechanical and/or electro-hydraulic components that need to be properly powered for performing specific functionalities of the appliance, as well as electronic components (such as dedicated and/or shared printed circuit boards) for powering and/or driving such electric, electro-mechanical and/or electro-hydraulic components (the latter thus acting as corresponding electric loads).

For example, a class of appliances make use of treatment fluids that need to be heated during the appliance operation for accomplishing the intended tasks, such as washing and/or drying of laundry or dishware.

For this reason, such appliances are usually provided with one or more electric loads for heating the treatment fluids (heating elements), which are able to convert electric energy into heat to be released to the treatment fluid to heat it up.

In many appliances, the heating element comprises an electric resistor that by Joule effect generates heat from an electric current flowing therethrough; the electric resistor is encased in a case of conductive material with interposition of an insulator material, thereby the electric resistor is not in electrical contact with, *i.e.* is insulated from the treatment fluid to be heated. When the treatment fluid has to be heated, line and neutral potentials of an AC electric power supply are fed to respective terminals of the electric resistor (for example, by closing proper switching elements) for allowing the latter to be energized.

As known, the electric loads may be affected by phenomena of dispersion of electric power towards earth or ground, which apart from increasing the power consumption, may pose safety problems.

Considering for example the case of heating elements for heating treatment fluids, insulation faults may affect the insulator material that insulates the electric resistor from the case, as a result of production defects or as a consequence of usage wear (particularly for washer-dryers, whose operation cause the electric resistors to be subjected to significant mechanical stress that may impair the electric insulation), thereby originating low resistance paths or even a short-circuit between the case and the electric resistor.

In such conditions, when the electric resistor is energized, an undesired flow of electric current (leakage current), may leak from, *e.g*., the AC electric power supply and the ground, at which the electric resistor case is typically kept.

The dispersion of electric power towards ground is to be avoided, since in case the AC distribution network in the user premises where the electric appliance is installed is properly protected, the protection devices intervene and cause the de-energization of all or at least sections of the user premises; even worse, when no proper protection exists, the risk of electric shock for the user is very high.

Some solutions known in the art make use of a substantially common approach according to which fault of the insulator material is tried to be prevented by pre-emptively acting on one or more specific parameters identified as being among the most important ones to determine the fault. For example, being an uncontrolled over-temperature of the electric resistor a possible cause of physical breakage or crack of the insulator material or of an at least partial detaching thereof from the electric resistor, many appliances are provided with overheating protection circuits for monitoring a temperature of the heating element or a temperature of the treatment fluid and aborting the operation of the appliance (possibly, displaying a proper error code) in case the monitored temperature rises a critical temperature.

Another solution is disclosed in EP 0 677 908 A2, which generally relates to an apparatus for automatically coupling an internal ground of an appliance to an external ground. Such document also discloses an apparatus for automatically detecting a leakage current, comprising a power supply for supplying an AC input voltage to an electric load of the appliance, switching means coupled between the electric load and the power supply, ground connection means for automatically coupling the internal ground of the appliance to a line of the power supply, current sensing means coupled between the internal ground and said line for detecting a current flowing therethrough to generate a current detection signal when the current is greater than a predetermined value, and switch drive means for generating, in response to the current detection signal, a switch drive signal to separate the power supply from the electric load.

### Summary of invention

The Applicant has realized that the known solutions are not satisfactory for modern technological requirements.

In particular, according to the Applicant, the approach providing overheating protection circuits does not protect the user and/or the appliance from dispersion of electric power towards ground of the heating element, but at most provisionally avoids that the insulator material of the heating element breaks or cracks because of an excessive thermal stress. Moreover, such an approach is not effective for protecting the user/appliance against dispersions of other electric loads present in the appliance (*e.g.* motors, pumps, and the like).

As far as EP 0 677 908 A2 is concerned, the Applicant believes that the solution disclosed in such document is not efficient in terms of safety, since it allows detecting the leakage current only after a certain time period the electric power supply has been coupled to the electric load, as well as in terms of power wastes.

Moreover, such solution checks if a leakage current exists between the electric power supply and ground without distinguishing the origin of such leakage current, thereby making the tracing of the failure cause of the appliance difficult.

Finally, the disclosed solution, having a high circuit complexity, is not easy to implement in modern appliances wherein the higher and higher number of functions for the same, or even lower, space occupation makes features like circuit simplicity and low-component circuits mandatory.

The Applicant has tackled the problem of devising a satisfactory solution able to overcome the above-discussed drawbacks.

The Applicant has found that by providing operative electric power (i.e. the whole electric power necessary for performing its functions) to a slave printed circuit board and hence to an electric load powered by the slave printed circuit board only if a master printed circuit board who power-supplies the slave printed circuit board evaluates that a power dispersion towards ground is not present or is low, it is possible to ensure the electrical safety of the appliance comprising such load and boards.

In other words, the Applicant has found that electrical safety of an appliance, in relation to the power dispersion towards ground of one of its electric loads (and/or slave printed circuit boards), may be ensured if, before providing the whole power supply (or operative electric power) to such slave printed circuit board, the possible power dispersion towards ground of the electric load (and/or of the slave printed circuit board power-supplying the electric load) is evaluated/detected, and the operative electric power is supplied to such slave printed circuit board (and hence to the electric load) only if the evaluated/detected power dispersion towards ground is not present or is low.

The solution according to one or more embodiments of the present invention relates to an electric appliance (for example, a laundry washing machine, a laundry washer/dryer, a laundry dryer, a dishwasher, a oven, a refrigerator, or the like). The electric appliance comprises an electric load (*e.g*, one or more electric heating elements, a motor, a pump, and the like), and a printed circuit board assembly for electronically managing the electric appliance. The printed circuit board assembly comprises a slave printed circuit board operatively associated with the electric load for driving it, and a master printed circuit board operatively associated with the slave printed circuit board and arranged for receiving an electric power supply of the electric appliance (for example, through line and neutral conductors) and for selectively providing/stopping the provision of an operative electric power to the slave printed circuit board for energization/de-energization thereof (and hence, for energization/de-energization of the electric load).

The master printed circuit board comprises a detection device (for example, an electric sensing resistor) for detecting a dispersion of electric power towards ground of the electric load and/or of the slave printed circuit board when the operative electric power (*i.e*. the whole power necessary to the slave printed board for completely and correctly performing its functions, and in particular for providing to the electric load the electric power necessary to the latter for completely and correctly performing its functions) is not provided to said slave printed circuit board, and for providing, in response to the detecting, a control parameter (*e.g*., voltage, current, electric power and the like) indicative of the dispersion of electric power towards ground. The master printed circuit board comprises also a control unit (for example, a microcontroller) configured for receiving the control parameter, comparing the control parameter to a preset threshold value or range of values, and enabling provision of the operative electric power to the slave printed circuit board according to a result of such comparison.

Preferably, the preset threshold value or range of values are preset (*e.g.,* by the microcontroller) according to a value of a chosen electric parameter (**e.g**. the amplitude of the voltage provided by the electric power supply, which value may be inputted by the user for example by a suitable input device, or which may be for example detected by the master printed circuit board itself, for example by a suitable detecting circuit comprised in the board). Moreover, the preset threshold value or range of values may be (*e.g*., automatically) updated according to any proper criterion (such as according to variations of the chosen electric parameter, for example the value of the amplitude of the voltage provided by the electric power supply, measured by the master printed circuit board).

According to an embodiment of the present invention, the control unit may be either configured for enabling provision of the operative electric power to the slave printed circuit board only if the control parameter is within the preset range of values, or the control unit may be configured for enabling provision of the operative electric power to the slave printed circuit board only if the control parameter is outside a preset range of values.

According to another embodiment of the present invention, the control unit may be either configured for enabling provision of the operative electric power to the slave printed circuit board only if the control parameter has a value above the preset threshold value, or the control unit may be configured for enabling provision of the operative electric power to the slave printed circuit board only if the control parameter has a value below the preset threshold value.

Preferably, the master printed circuit board comprises a first switching element for connecting/disconnecting a first conductor of the electric power supply to a first terminal of the slave printed circuit board, and the slave printed circuit board comprises a second switching element for connecting/disconnecting a second conductor of the electric power supply to a second terminal of the slave printed circuit board; in this way, the control unit may enable/disable provision of the operative electric power to the slave printed circuit board by closing/opening the first switching element and the second switching element thereby connecting/disconnecting the first conductor and the second conductor to the first terminal and the second terminal, respectively, of the slave printed circuit board, and the detection device may detect the dispersion of electric power towards ground and provide the control parameter when the first switching element and the second switching element are both opened.

Advantageously, the detection device is configured for being run through by a leakage current indicative of the dispersion of electric power towards ground.

In a preferred but not limiting embodiment, the detection device is placed between a first terminal of the first switching element connected to a first portion of the first conductor and a second terminal of the first switching element connected to a second portion of the first conductor; in this way, the detection device can be configured such as to detect the leakage current flowing through the first portion of the first conductor, the detection device, the second portion of the first conductor, the electric load, and a ground of the electric appliance.

Advantageously, the detection device comprises a sensing resistor having a first terminal and a second terminal connected to the first terminal and the second terminal of the first switching element, respectively.

The control parameter may be a current, an electric power, a photon intensity, or a voltage depending on the dispersion of electric power towards ground detected by the detection device.

In an embodiment of the present invention, the control unit is connected to the detection device for receiving said voltage depending on the dispersion of electric power towards ground, and is configured to compare said voltage to a voltage threshold value or range of value corresponding to the preset threshold value or range of values.

In a non limiting arrangement, the electric load comprises at least one electric heating element for heating treatment fluids during heating operations of the electric appliance; for example, such at least one electric heating element may be configured for being powered by the operative electric power and for generating heat therefrom.

Such at least one electric heating element may comprise at least one electric resistor connected between a first terminal and a second terminal of the electric heating element for receiving the operative electric power, a case for housing the at least one electric resistor (with the case that is preferably connected to the ground of the electric appliance), and an insulating coating between the at least one electric resistor and the case for electrically insulating the at least one electric resistor from the case. The detection device may be configured for detecting the dispersion of electric power towards ground through the insulating coating for checking insulation degree thereof.

Without losing of generality, the electric appliance may be a laundry washing machine, a laundry washer/dryer, a laundry dryer, a dishwasher, a oven, or a refrigerator.

Thanks to the present invention, the dispersion of electric power towards ground affecting a selected electric load (and/or a selected slave printed circuit board, e.g. the slave printed circuit board associated with the selected electric load) is precisely and easily detected as soon as it takes place, but always before the operative electric power is fed to the electric load (and/or to the slave printed circuit board). Therefore, the present invention prevents electric power from dispersing towards ground when the electric load is energized, which avoids to the user annoyances deriving by de-energization of all or at least sections of the user premises wherein the appliance is installed due to intervention of protection devices, as well as makes the user safe from electric shock when no proper protection devices exist.

Moreover, the present invention allows tracing the cause of the failure, since the origin of the dispersion of electric power towards ground is univocally associated to the selected electric load.

### Brief description of the annexed drawings

These and other features and advantages of the present invention will be made apparent by the following description of some exemplary and non limitative embodiments thereof; for its better intelligibility, the following description should be read making reference to the attached drawings, wherein:
**Figure 1** schematically shows an electric appliance wherein the solution according to one or more embodiments of the present invention may be applied, and
**Figure 2** schematically shows in terms of functional blocks the solution according to an embodiment of the present invention.

### Detailed description of preferred embodiments of the invention

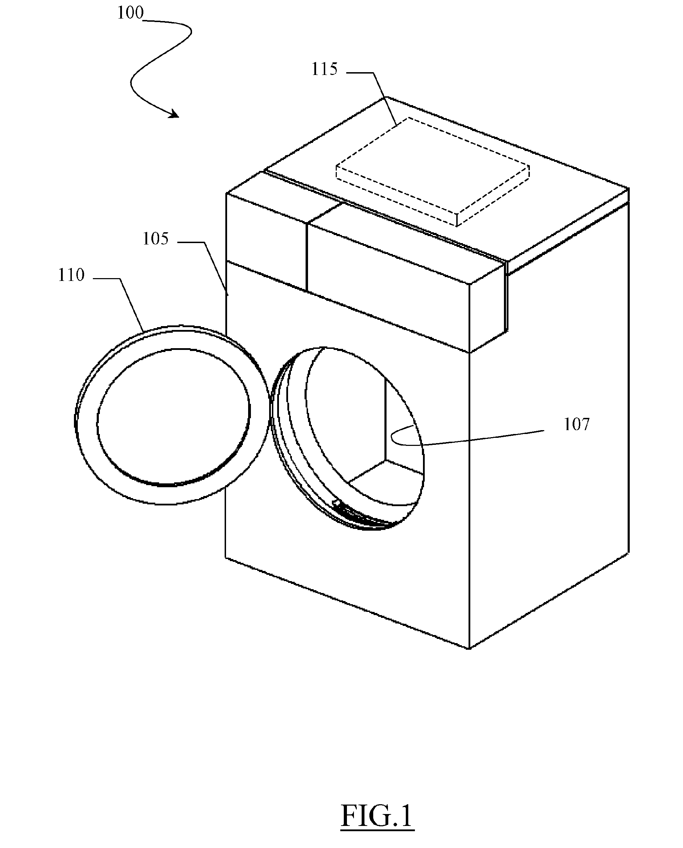

Referring now to the drawings, **Figure 1** schematically shows an electric appliance or, shortly, appliance **100**, for example for domestic use *(i.e.,* a household appliance), wherein the solution according to one or more embodiments of the present invention may be applied. The appliance **100** may for example be a laundry washing machine, a laundry washer/dryer or a laundry dryer, e.g. a tumble dryer (as generically illustrated in the figure, and to which reference will be made in the following by way of a non-limiting example only), but the principle of the present invention also apply to dishwashers, ovens, refrigerators and any other appliance generally equipped with electric loads that, powered by an electric power supply, could be intrinsically subjected to phenomena of dispersion of electric power towards ground.

The appliance **100** preferably comprises a substantially parallepiped-shaped cabinet **105,** which encloses an inner compartment **107** apt to contain items to be treated (such as laundry to be washed and/or dried), and accessible through an access door **110** (shown in an open configuration) provided preferably on a front panel of the cabinet **105** for loading/unloading the items.

The inner compartment **107** of the household appliance **100** also preferably accommodates, not visible in such figure, electro-mechanical components, such as motor for causing a rotating drum to rotate, or solenoid valves, as well as electric components, such as heating elements for causing treatment fluids (*e.g*., water-based cleaning solutions, rinsing water and/or air) to be heated, and electro-hydraulic components, such as valves for causing the treatment fluids to be loaded and discharged during the washing/drying cycle.

The inner compartment **107** of the appliance **100** further accommodates electronic components **115** (schematically represented by a generic rectangle having dashed perimeter lines) for causing both the electro-mechanical components, the electric components and the electro-hydraulic components to be electronically controlled, driven (*e.g*., powered or energized) and/or monitored (thus acting as corresponding electric loads).

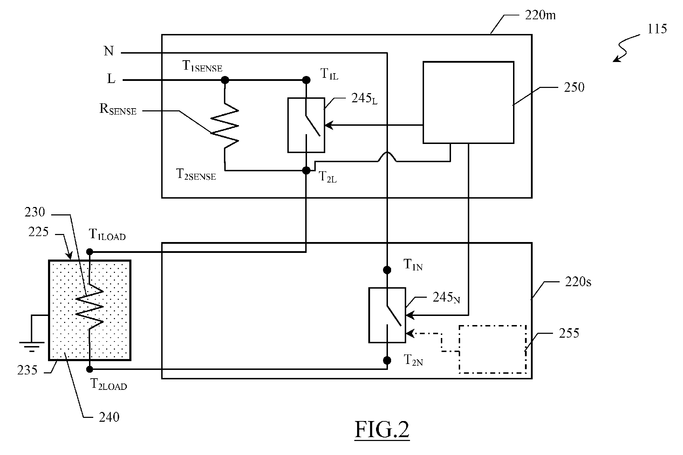

Modern electronic components **115** are typically in the form of a printed circuit board (or PCB) assembly, whose implementation according to an embodiment of the present invention is schematically shown in terms of functional blocks in Figure 2. The PCB assembly 115 is advantageously configured for electronically managing the operation of the appliance, such as controlling, driving and/or monitoring the various electric loads; however, for the sake of conciseness and clarity, in the following only functional blocks of the PCB assembly 115 directly involved in heating operations by which the treatment fluid is properly heated will be considered.

In this regard, the PCB assembly **115** may comprise two or more, *e.g*. a plurality of PCBs; advantageously, the PCB assembly **115** comprises PCBs **220s** (one, in the example in the figure) acting as "slave" PCBs (*i.e.,* peripheral or secondary PCBs whose operation is requested only if there is a need for the specific operations they are designed to perform), and further PCBs **220m** (one, in the example in the figure) acting as "master" PCBs (*i.e.*, main or primary PCBs coordinating the slave PCBs and activating them individually, for example based on a proper communication protocol).

The slave PCB **220s** is associated with *(i.e.,* it drives, controls, and/or monitors) an electric load **225,** which may comprise one or more heating elements, like washing liquid heating resistors, or for example a motor, a pump, a compressor, etc. In the embodiment illustrated in the enclosed figures the electric load **225** is for example an electric heating element (*e.g*. an electric resistor). Advantageously the master PCB **220m,** which receives the electric power supply (typically, an AC electric power supply, not shown) of the appliance, preferably selectively enables a selected slave PCB (the slave PCB **220s,** in the case at issue) for driving (*i.e.* providing/stopping an operative electric power, such as an operative electric current) to the electric load **225** (a heating element in the example of enclosed drawings) for energization/de-energization thereof.

In the illustrated example the term "operative electric power" is intended to identify the electric power fed to the slave PCB **220s** and hence to the electric load 225 for energization/de-energization thereof, and therefore the whole electric power necessary to the electric load for correctly and completely performing its functions (*e.g*. heating in the case of an electric heater), as opposed to the dispersion of electric power towards ground through the slave PCB 220s and/or the electric load 225, which in the example at issue is in the form of a current leaking through the slave PCB 220s (and the electric load 225) or leakage current, when no operative electric power is provided to the slave PCB 220s (and hence to the electric load 225).

If the electric load 225 is a heating element, it is able to generate heat (from electric energy, such as an electric current) to be released to the treatment fluid, thereby heating it up to a desired temperature (typically depending on preferred appliance settings).

In the embodiment illustrated in enclosed figures, preferably, the heating element comprises one (as in the shown example) or more electric resistors **230** that, by Joule effect, allows generating heat from the operative electric power fed thereto by the slave PCB **220s;** the electric resistor **230** is encased in a case **235** of conductive material (typically grounded at a reference voltage, *e.g*., 0V, or ground), with interposition (partial or total, as exemplarily shown in the figure) of an insulator material **240** apt to prevent the electric resistor **230** from being in electrical contact with the treatment fluid to be heated.

In operation, the electric load **225** can be energized by feeding it with the required operative electric power by line and neutral potentials of the AC electric power supply, preferably through corresponding line conductor **L** and neutral conductor **N.** Advantageously, the line conductor **L** and the neutral conductor **N** can be connected to/disconnected from terminals of other electric, electronic and/or electro-mechanic components (not shown) of (or associated with) the slave PCB **220s.** In the example herein disclosed, the line conductor **L** and the neutral conductor **N** can be connected to/disconnected from a terminal T_{1LOAD} and another terminal **T_{2LOAD}** of the electric load **225** (and hence to/from respective terminals of the electric resistor **230),** respectively, preferably by means of corresponding electrically-operated switching elements (*e.g*., relays) **245_{L}** and **245_{N}** mechanically supported by and electrically connected to the master PCB **120m** and the slave PCB 120s, respectively (albeit other arrangements of the relays **245_{L}** and **245_{N}** are possible without departing from the principles of the present invention).

Each relay **245_{L},245_{N}** preferably comprises a first terminal **T_{1L},T_{1N}** connected to a first portion of the line conductor **L** and to a first portion of the neutral conductor **N**, respectively, and a second terminal **T_{2L},T_{2N}** preferably connected to a second portion of the line conductor **L** (in turn connected to the terminal **T**_{1LOAD}) and to a second portion of the neutral conductor **N** (in turn connected to the terminal **T_{2LOAD}),** respectively; in this way, a closure/opening of the relay **245_{L},245_{N}** causes the first terminal **T_{1L}, T_{1N}** (and hence the first portions of line conductor **L** and neutral conductor **N)** to be connected to/disconnected from the respective second terminal **T_{2L},T_{2N}** (and hence to/from the second portions of line conductor **L** and neutral **N** conductor, respectively), and thus the electric load **225** (in this example a heating element) to be connected to/disconnected from the electric power supply (and hence to be provided/not provided with the operative electric power).

The master PCB **120m** further comprises a microcontroller **250** which in general accomplishes management, processing and control functions. Amongst other things, the microcontroller **250** is configured for controlling the relays **245_{L}** and **245_{N}** thus enabling/disabling the provision of the operative electric power to the slave PCB **220s** (hence to the electric load **225).**

Moreover, as will be discussed shortly, if the electric load **225** is a heating element comprising an insulator material **240,** the microcontroller **250** may be preferably also configured for checking an insulation degree *(i.e.,* a dispersion of electric power towards ground) of the insulator material **240** when the relays **245_{L}** and **245_{N}** are both opened (and thus the electric load **225** is not energized).

In this respect, according to the present invention, the master **PCB 120m** further comprises a detection device for detecting a possible dispersion of electric power towards ground when the operative electric power is not yet provided to the electric load **225**, and for providing, in response to said detecting, a control parameter indicative of the dispersion of electric power towards ground, whereas the microcontroller **250** cooperates with such detection element for receiving the control parameter, comparing the control parameter to a preset threshold value or range of values (depending on the admitted dispersion of electric power towards ground), and enabling provision of the line and neutral potentials (hence of the operative electric power) to the slave **PCB 220s** (e.g. by closing the relays **245_{L},245_{N}**) according to a result of such comparison. For example, the microcontroller **250** may be configured for enabling provision of the operative electric power to the slave **PCB 220s** (hence to the electric load **225)** only if the control parameter is within the preset range.

Without losing of generality, alternatively the microcontroller **250** may be configured for enabling provision of the operative electric power to the electric load **225** only if the control parameter is outside the preset range. In another embodiment, the microcontroller **250** may be configured for enabling provision of the operative electric power to the slave **PCB 220s** only if the control parameter has a value above the preset threshold value. In a still another embodiment, the microcontroller **250** may be configured for enabling provision of the operative electric power to the slave PCB **220s** only if the control parameter has a value below the preset threshold value.

Preferably, the preset threshold value or range of values are preset (*e.g*., by the microcontroller **250)** according to a value of a chosen electric parameter (*e.g*., the electric power supply). Moreover, the preset threshold value or range of values may be (*e.g*., automatically) updated according to any proper criterion (such as according to variations of the chosen electric parameter).

In the exemplary but not limiting disclosed embodiment, the detection device is a sensing electric resistor (or sensing resistor) **R_{SENSE},** and the dispersion of electric power towards ground is detected as leakage current flowing therethrough, and the control parameter is a voltage depending on the leakage current flowing through the sensing resistor **R_{SENSE}.** Preferably, but not necessarily, the sensing resistor **R_{SENSE}** has a terminal **T_{1SENSE}** connected to the terminal **T_{1L}** of the relay **245_{L}** and another terminal **T_{2SENSE}** connected to the terminal **T_{2L}** of the relay **245_{L}** *(i.e.,* the sensing resistor **R_{SENSE}** is placed in parallel to the relay 245_{L}). In such configuration, although the relays **245_{L},245_{N}** are open, the sensing resistor **R_{SENSE}** can still establish an electrical coupling from electric power supply to ground (for example through the first portion of the line conductor **L,** the sensing resistor **R_{SENSE}** itself, the second portion of the line conductor **L**, the electric resistor **230,** the insulator material **240** and the case **235**) according to an insulation degree of the insulator material **240**.

In this way, if the insulator material **240** is not perfectly insulating, a leakage current will flow through the sensing resistor **R_{SENSE}** and a voltage will develop at the terminal **T_{2SENSE};** as should be understood, in such condition the voltage at the terminal **T_{2SENSE}** will be lower than the voltage at the terminal **T_{1SENSE}** (that is forced to the line potential) to an extent depending on the value of the leakage current flowing through the sensing resistor **R_{SENSE}** and the resistance value thereof. Otherwise, no leakage current will flow through the sensing resistor **R_{SENSE},** condition wherein the detection voltage substantially equals the voltage at the terminal **T_{1SENSE}** (safety condition), or has a prefixed value, different form the voltage at the terminal **T_{1SENSE},** (for example because of the low current circulating through the sensing resistor **R_{SENSE}** towards the microcontroller **250)** but also different form the voltage at the terminal **T_{2SENSE}** in case of a power dispersion.

The microcontroller **250** monitors the voltage at the terminal **T_{2SENSE}** (and hence at the terminal **T_{2L}** of the relay **245_{L}).** In this way, the microcontroller **250** can compare such voltage to a voltage threshold value or range of values corresponding to the preset value or range of values, and thereby enable provision of the operative electric power to the heating element **225** if the voltage has a specific relation with said threshold value or range of values (*e.g.* if the voltage is within- or without, according to the chosen implementation- a preset voltage range ); the microcontroller **250** commands the closure of both the relays **245_{L},245_{N}** only if such condition is verified.

As visible in **Figure 2**, the slave **PCB 220s** may further comprise a processing and control unit **255** cooperating with the relay **245_{N}** for commanding the closure thereof thereby enabling provision of the line and neutral potentials (hence of the operative electric power) to the slave **PCB 220s** (thus, to the electric load **225**). For instance, the processing and control unit **255** may be powered by the voltage provided by (or derived from) the line conductor **L** (for example, taken from the terminal **T_{2L}**, connection not shown) and the neutral conductor **N** (for example, taken from the terminal **T_{1N}**, connection not shown). In this way, if no power dispersion towards ground is detected by the microcontroller **250,** the microcontroller **250** closes the relay **245_{L}** (thereby enabling provision of the operative electric power to the processing and control unit **255),** and the processing and control unit **255** closes the relay **245_{N},** thereby enabling provision of the operative electric power to the electric load **225.** Conversely, if power dispersion towards ground is detected by the microcontroller **250,** the relay **245_{L}** is open, thereby provision of the operative electric power to the processing and control unit **255** is disenabled (since the latter is electrically connected only to the neutral conductor through the terminal **T_{1N});** then, the relay **245_{N}** is open as well (thereby the provision of the operative electric power to the electric load **225** is disenabled).

Preferably, but not necessarily, the sensing resistor **R_{SENSE}** has a high resistance value *(e.g*., grater than 100 KΩ, such as 1 MΩ), so that the voltage at the terminal **T_{2L}** is responsive also to very small leakage currents (however, as will be readily understood, the resistance value of the sensing resistor **R_{SENSE}** may be chosen according to specific design parameters).

Clearly, the appliance according to the invention may comprise more slave or master PCBs.

In addition, although in the present description explicit reference has been made to slave and master PCBs, this should not be understood in a restrictive way; in fact, according to the used communication protocol, the slave PCBs may also perform master functions, whereas the master PCBs may also perform slave functions.

Moreover, although in the present description explicit reference has been made to distinct and separated master and slave PCBs, this should not be construed limitatively. In fact, the same considerations apply if the master and slave PCBs are identifiable functionally-different portions of a same PCB. Furthermore, as herein considered, the term "slave PCB" is intended in its widest meaning of any group of electric, electro-mechanic and/or electronic components carrying out functions related to the driving of the electric load.

The slave PCB may also be associated with a plurality of different or equivalent electric loads, which can be individually selected and/or activated by means of additional switching elements. Moreover, the slave PCB may have a different circuit configuration; for example, the slave PCB may be provided with additional switching elements (*e.g*., properly controlled by the microcontroller and/or the processing and control unit). Additionally or alternatively, the slave PCB may be provided with further electric, electronic and/or electro-mechanic components for being powered only if no power dispersion towards ground is detected, and for driving the electric load only if such condition is verified.

The switching elements are not necessarily relays, but also, for example, electronic switches such as power (BJT, MOS, and the like) transistors, as well as they can be in any number. Moreover, the arrangement of the switching elements herein described is not strictly necessary, and several modifications are possible; in this respect, the switching elements may be arranged and/or distributed differently in the master and/or slave PCBs. For example, although in the present description the switching element within the master PCB has been described as "insulating" the electric load from the line conductor, whereas the switching element within the slave PCB has been described as "insulating" the electric load from the neutral conductor, the present invention may be equivalently configured such as the switching element within the master PCB "insulates" the electric load from the neutral side and the switching element within the slave PCB "insulates" the electric load from the line conductor).

The same considerations apply if the detection device is implemented differently; for example, it is possible to provide more sensing resistors (*e.g*., arranged in series or parallel configurations), and/or other electric elements, for example according to the provided control parameter. In fact, the control parameter may be a voltage (as exemplarily described in the present description), or a current depending on the leakage current flowing through the sensing resistor; in this respect, the detection device and/or the microcontroller may comprise transistor current mirrors for taking such current and properly processing it. Analogous considerations apply if the control parameter is an electric power, or a photon intensity depending on the leakage current flowing through the sensing resistor. In the latter case, the detection device and/or the microcontroller may comprise a light emitting diode for converting the leakage current into light and a photodector (such as a photodiode) for re-converting such light into a corresponding current (*e.g.*, equal to or proportional to the leakage current).

## Claims

1. An electric appliance **(100)** comprising an electric load **(225),** and a printed circuit board assembly **(115)** for electronically managing the electric appliance **(100),** the printed circuit board assembly comprising:
- a slave printed circuit board **(220s)** operatively associated with said electric load **(225)** for driving it, and
- a master printed circuit board **(220m)** operatively associated with said slave printed circuit board **(220s)** and arranged for receiving an electric power supply **(L,N)** of the electric appliance and for selectively providing/stopping the provision of an operative electric power to the slave printed circuit board **(220s)** for energization/de-energization thereof,
**characterized in that**
the master printed circuit board **(220m)** comprises:
- a detection device **(R_{SENSE},T_{1SENSE},T_{2SENSE})** for detecting a dispersion of electric power towards ground of the electric load **(225)** and/or of the slave printed circuit board **(220s)** when the operative electric power is not provided to said slave printed circuit board **(220s),** and for providing, in response to said detecting, a control parameter indicative of the dispersion of electric power towards ground, and
- a control unit **(250)** configured for receiving the control parameter, comparing the control parameter to a preset threshold value or range of values, and enabling provision of the operative electric power to the slave printed circuit board (220s) according to a result of such comparison.

2. The electric appliance (**100**) according to Claim 1, wherein the control unit (**250**) is either configured for enabling provision of the operative electric power to said slave printed circuit board (**220s**) only if the control parameter is within the preset range of values, or the control unit is configured for enabling provision of the operative electric power to said slave printed circuit board (**220s**) only if the control parameter is outside a preset range of values.

3. The electric appliance **(100)** according to Claim 1, wherein the control unit **(250)** is either configured for enabling provision of the operative electric power to said slave printed circuit board **(220s)** only if the control parameter has a value above the preset threshold value, or the control unit is configured for enabling provision of the operative electric power to said slave printed circuit board **(220s)** only if the control parameter has a value below the preset threshold value.

4. The electric appliance **(100)** according to any of the preceding Claims, wherein the master printed circuit board **(220m)** comprises a first switching element **(245_{L})** for connecting/disconnecting a first conductor **(L)** of the electric power supply **(L,N)** to a first terminal **(T_{1LOAD})** of the electric load **(225),** and the slave printed circuit board **(220s)** comprises a second switching element **(245_{N})** for connecting/disconnecting a second conductor **(N)** of the electric power supply **(L,N)** to a second terminal **(T_{2LOAD})** of the electric load **(225),** the control unit **(250)** enabling/disabling provision of the operative electric power to the electric load **(225)** by closing/opening the first switching element **(245_{L})** and the second switching element **(245_{N})** thereby connecting/disconnecting the first conductor **(L)** and the second conductor **(N)** to the first terminal and the second terminal, respectively, of the electric load **(225)**, and the detection device **(R_{SENSE},T_{1SENSE},T_{2SENSE})** detecting the dispersion of electric power towards ground of the electric load **(225)** and/or of the slave printed circuit board **(220s)** and providing the control parameter when the first switching element **(245_{L})** and the second switching element (**245_{N}**) are both opened.

5. The electric appliance **(100)** according to any of the preceding Claims, wherein the detection device **(R_{SENSE},T_{1SENSE},T_{2SENSE})** is configured for being run through by a leakage current indicative of the dispersion of electric power towards ground.

6. The electric appliance **(100)** according to Claim 4, wherein
the detection device **(R_{SENSE},T_{1SENSE},T_{2SENSE})** is configured for being run through by a leakage current indicative of the dispersion of electric power towards ground of the electric load **(225)** and/or of the slave printed circuit board **(220s),** and
the detection device **(R_{SENSE},T_{1SENSE},T_{2SENSE})** is placed between a first terminal **(T_{1L})** of the first switching element **(245_{L})** connected to a first portion of the first conductor **(L)** and a second terminal **(T_{2L})** of the first switching element **(245_{L})** connected to a second portion of the first conductor **(L),** the detection device **(R_{SENSE},T_{1SENSE},T_{2SENSE})** being configured to detect the leakage current flowing through the first portion of the first conductor **(L),** the detection device **(R_{SENSE},T_{1SENSE},T_{2SENSE}),** the second portion of the first conductor **(L),** the electric load **(225),** and a ground of the electric appliance **(100).**

7. The electric appliance **(100)** according to Claim 6, wherein the detection device **(R_{SENSE},T_{1SENSE},T_{2SENSE})** comprises a sensing resistor **(R_{SENSE}),** a first terminal **(T_{1SENSE})** and a second terminal **(T_{2SENSE})** of the sensing resistor being connected to the first terminal **(T_{1L})** and the second terminal **(T_{2L})** of the first switching element **(245_{L}),** respectively.

8. The electric appliance **(100)** according to any Claim from 1 to 7, wherein the control parameter is a current depending on the dispersion of electric power towards ground detected by the detection device **(R_{SENSE},T_{1SENSE},T_{2SENSE})**.

9. The electric appliance **(100)** according to any Claim from 1 to 7, wherein the control parameter is an electric power depending on the dispersion of electric power towards ground detected by the detection device **(R_{SENSE},T_{1SENSE},T_{2SENSE}).**

10. The electric appliance **(100)** according to any Claim from 1 to 7, wherein the control parameter is a photon intensity depending on the dispersion of electric power towards ground detected by the detection device **(R_{SENSE},T_{1SENSE},T_{2SENSE}).**

11. The electric appliance **(100)** according to any Claim from 1 to 7, wherein the control parameter is a voltage depending on the dispersion of electric power towards ground detected by the detection device **(R_{SENSE},T_{1SENSE},T_{2SENSE}).**

12. The electric appliance **(100)** according to Claim 11, wherein the control unit **(250)** is connected to the detection device **(R_{SENSE},T_{1SENSE},T_{2SENSE})** for receiving said voltage depending on the dispersion of electric power towards ground, the control unit **(250)** being configured to compare said voltage to a voltage threshold value or range of value corresponding to the preset threshold value or range of values.

13. The electric appliance **(100)** according to any of the preceding Claims, wherein the electric load **(225)** comprises at least one electric heating element for heating treatment fluids during heating operations of the electric appliance **(100),** the at least one electric heating element being configured for being powered by the operative electric power and for generating heat therefrom.

14. The electric appliance **(100)** according to Claim 13, wherein the at least one electric heating element comprises:
at least one electric resistor **(230)** connected between a first terminal **(T_{1LOAD})** and a second terminal **(T_{2LOAD})** of the electric heating element for receiving the operative electric power,
a case **(235)** for housing the at least one electric resistor, the case being connected to the ground of the electric appliance,
an insulating coating **(240)** between the at least one electric resistor **(230)** and the case **(235)** for electrically insulating the at least one electric resistor **(230)** from the case **(235),** the detection device detecting the dispersion of electric power towards ground through the insulating coating **(240)** for checking insulation degree thereof

15. The electric appliance **(100)** according to any of the preceding Claims, wherein the electric appliance **(100)** is a laundry washing machine, a laundry washer/dryer, a laundry dryer, a dishwasher, a oven, or a refrigerator.
